# EUROPEAN PATENT SPECIFICATION

(11) **EP 3 826 180 B1**
(45) Date of publication and mention of the grant of the patent: **23.07.2025**
(21) Application number: 19210570.8
(22) Date of filing: 21.11.2019
(51) Int. Cl.: H03K 5/135

(54) **TIME-DELAY CIRCUIT FOR A DIGITAL SIGNAL, PARTICULARLY FOR A CLOCK SIGNAL**
VERZÖGERUNGSSCHALTUNG FÜR EIN DIGITALES SIGNAL, INSBESONDERE FÜR EIN TAKTSIGNAL
CIRCUIT TEMPORISÉ POUR SIGNAL NUMÉRIQUE, EN PARTICULIER POUR UN SIGNAL D'HORLOGE

(43) Date of publication of application: 26.05.2021
(73) Proprietor: Integrated Device Technology, Inc., San Jose CA 95138 (US)
(72) Inventor: AGRAWAL, Vikas, San Jose, CA California 95116 (US); QIU, Feng, Fremont, CA California 94538 (US); HSIAO, Cheng Wen, San Jose, CA California 95148 (US); GUO, Yimu, 5560 Lexington, CA California 95123 (US)
(74) Representative: Lippert Stachow Patentanwälte Rechtsanwälte Partnerschaft mbB

(56) References cited:
- EP-A2- 0 600 815
- US-A1- 2003 085 734
- US-B1- 6 483 871

## Description

The invention relates to a time-delay circuit for a digital signal, particularly for a clock signal and it is defined by the claims.

Time-delay circuits are widely used in electronic circuits, for example for delaying the clock signals of electronic circuits. Time-delay circuits known from the prior art commonly use Resistor-Capacitor (RC) components producing the time delay between the input signal and the delayed output signal. However, the use of RC-components has limitations on minimum pulse width and frequency of operation. These time-delay circuits further suffer from large variations over process corners and temperature corners, which requires components trimming during manufacturing, which introduces higher manufacturing costs.

Other architectures known from the prior art, like Delayed Locked Loop (DLL) circuits, are complex and costly. Due to the complexity these circuits have a large footprint regarding the required chip size.

US 6,483,871 B1 discloses a digital signal phase detector comprising a first circuit arranged to provide a phase difference signal representative of both the clock period of a clock signal and the difference in phase between the clock and a data signal, and a second circuit arranged to provide a reference signal representative of a clock period of the clock signal. At least one of the first and second circuits is coupled to a set point control signal and the corresponding output signal is representative of that set point control signal. A comparison of the phase difference signal with the reference signal provides an indication of the difference between the desired set point of the circuit and the phase difference between the clock and the data signal.

US 2003/0085734 A1 discloses an unclocked, digital sequencer circuit having flexibly ordered leading and trailing edges on the output signals. The sequencer circuit of the invention includes a dual-input latch that detects only leading edges on a first input terminal and only trailing edges on a second input terminal. A delay line provides successively delayed input signals. Two delayed input signals are coupled to the first and second input terminals of each of two or more dual-input latches that provide a set of sequencer output signals. The sequence of the output signal edges depends on which delayed input signals are selected to drive each dual-input latch. In one embodiment, the selection of delayed input signals to drive the first and second input terminals of the dual-input latches is programmable. Thus, the sequence of the leading edges on the output signals is programmable, and the sequence of the trailing edges is independently programmable.

It is an object of the present invention to provide a time-delay circuit which is simple and easy to manufacture, requires a minimum of space, has minimum power consumption and can be used over a wide frequency range, especially with high frequencies.

According to the invention the object is solved by a time-delay circuit for a digital signal, particularly for a clock signal, comprising:
an input for the digital signal;
an oscillator for generating an internal clock signal;
at least one delay channel adding a certain delay to the digital input signal based on the internal clock signal; and
an output for a delayed digital signal.

The time-delay circuit according to the invention comprises an oscillator for generating an internal clock signal. This internal clock signal is used by the at least one delay channel to produce a certain time-delay. Since the delay of the at least one delay channel bases on the internal clock signal and not on RC components the time-delay circuit according to the invention can support higher input frequencies at the input. In general, the supported input frequencies only relate to the frequency of the internal clock signal produced by the oscillator. The produced time delay must be smaller than the period of the maximum supported frequency, because otherwise the next input pulse would arrive before the previous pulse is delayed and the next pulse would be missed. Thus, the maximum supported frequency is 1/T_{delay} produced by the time-delay circuit. Furthermore, the time-delay circuit according to the invention is easy to manufacture, requires a minimum of space and the required power for the oscillator and the at least one delay channel is also limited.

According to the invention the time-delay circuit comprises multiple delay channels, wherein each delay channel adds a certain delay to a part of the digital input signal based on the internal clock signal, and wherein the delayed digital signal is an aggregation of the delayed parts of the input signal by the multiple delay channels.

The input signal is split into parts and assigned to different channels of the time-delay circuit according to the invention. The parts of the input signal are advantageously separate pulses of the digital input signal. For example, the time-delay circuit comprises two delay channels, so that the incoming pulse of the digital input signal are alternatively respectively sequentially assigned to the two respectively more delay channels. Thus, the maximum supported frequency has been doubled or further enhanced for more delay channels. The supported frequency can be further increased by using more delay channels. The delayed parts of the input signal, i.e. the assigned pulses, are aggregated at the output to produce the total delayed signal.

Pursuant to a variant of the invention the multiple delay channels have the same or different delays. If the multiple delay channels have the same delay, the parts, i.e. pulses, of the input signal are equally assigned to the multiple channels and if the multiple delay channels have different delays, the parts of the input signal are preferably unequally distributed to the multiple channels, particularly in such a ratio that the aggregated output signal is a delayed version of the input signal.

In a variant of the invention the certain time delay of the delay channel is adjustable, particularly for each delay channel. The certain delay of a delay channel is for example adjusted by changing the division rate of the internal clock signal. By adjusting the certain delays of the delay channels the time-delay circuit according to the invention can be customized for different applications.

According to a variant of the invention the time-delay circuit further comprises a delay selector for adjusting the certain delay of the at least one delay channel. The delay selector can for example adjust the division rate of the internal clock signal for each delay channel.

Pursuant to an advantageous variant of the invention the at least one delay channel adjusts the certain time delay by dividing the internal clock signal, preferably within each channel for multiple delay channels. Such a frequency division is easy to implement and has low power consumption.

In an advantageous variant of the invention the oscillator is a process, voltage and temperature compensated oscillator. Thus, the time-delay circuit according to the invention is mainly independent of process, voltage and temperature variations.

Pursuant to the invention the time-delay circuit further comprises an edge detector for the digital input signal. The edge detector assigns the rising edge of the digital input signal to a first part of the delay channel and the falling edge of the digital input signal to a second part of the delay channel. Thus, the first part of the delay channel is designed to delay the rising edge of the digital input signal and the second part of the delay channel is designed to delay the falling edge of the delay channel. For example, each part of the delay channel comprises separate delay components for delaying the rising respectively falling edge of the digital input signal. Thus, the digital input signal is first divided into the rising and falling edges and afterwards these separated rising and falling edges are assigned to the first part and second part of the delay channel. In this way short input pulses can be processed. According to a preferred variant of the invention the edge detector is part of the input of the time-delay circuit and/or part of the delay channel, particularly of each of the multiple delay channels.

According to the invention the output of the delay channel aggregates the delayed signals for rising edge and the falling edge and thereby provides the delayed output signal of the delay channel. In a single channel time-delay circuit the output of the delay channel corresponds to the output of the time-delay circuit and in a multi-channel time-delay circuit the delayed outputs of the multiple delay channels are aggregated by the output of the time-delay circuit.

Pursuant to a preferred variant of the invention the at least one delay channel comprises multiple delay components, each providing a delay to the input signal of the delay channel. The certain delay of the at least one delay channel is defined by a selection of one or more of the delays provided by the multiple delay components. Thus, one or more of the multiple delay components can be selected define the certain delay of the delay channel. The selection of the delay components can be performed by the delay selector for adjusting the certain delay of the at least one delay channel.

In a further preferred variant of the invention the at least one delay channel comprises a multiplexer for selecting the one or more delays provided by the multiple delay components. Thus, the input signal of the delay channel is forwarded to all delay components and the multiplexer selects the relevant delayed output signals of the multiple delay components of the delay channel to provide the certain delay of the delay channel. Therefore, the input signal of the delay channel is processed, i.e. delayed, by all delay components, but the multiplexer selects only the relevant signals of multiple delay components to provide the certain delay of the delay channel. The multiplexer can be for example controlled by the delay selector.

Pursuant to a further variant of the invention the multiple delay components are programmable, i.e. the delay provided by the delay components can be adjusted by programming. In this way the provided delay can be further adjusted.

According to an advantageous variant of the invention the oscillator is programmable. Thus, the frequency of the oscillator can be adjusted to different frequencies. Thereby the time-delay circuit according to the invention can be customized for different applications.

The time-delay circuit according to the invention can be integrated into another integrated circuit providing the digital input signal and/or using the delayed digital output signal of the time-delay circuit. Alternatively, the time-delay circuit according to the invention can be implemented in a separate integrated circuit and connected to other circuits for example by means of a printed circuit board.

In the following the invention will be explained with respect to the embodiments shown the figures. It shows:
- Fig. 1: a block diagram of a first embodiment of a time-delay circuit which does not correspond to the claimed subject matter,
- Fig. 2: a block diagram of a second embodiment of a time-delay circuit according to the invention,
- Fig. 3: signal diagrams for a single channel, which does not correspond to the claimed subject matter, and dual channel time-delay circuit according to the invention,
- Fig. 4: a signal diagram for a dual channel time-delay circuit with different delay components for the rising and falling edges,
- Fig. 5: a schematic block diagram of a third embodiment of a time-delay circuit according to the invention, and
- Fig. 6: a schematic block diagram of different embodiments of time-delay circuits according to the invention combined in one diagram.

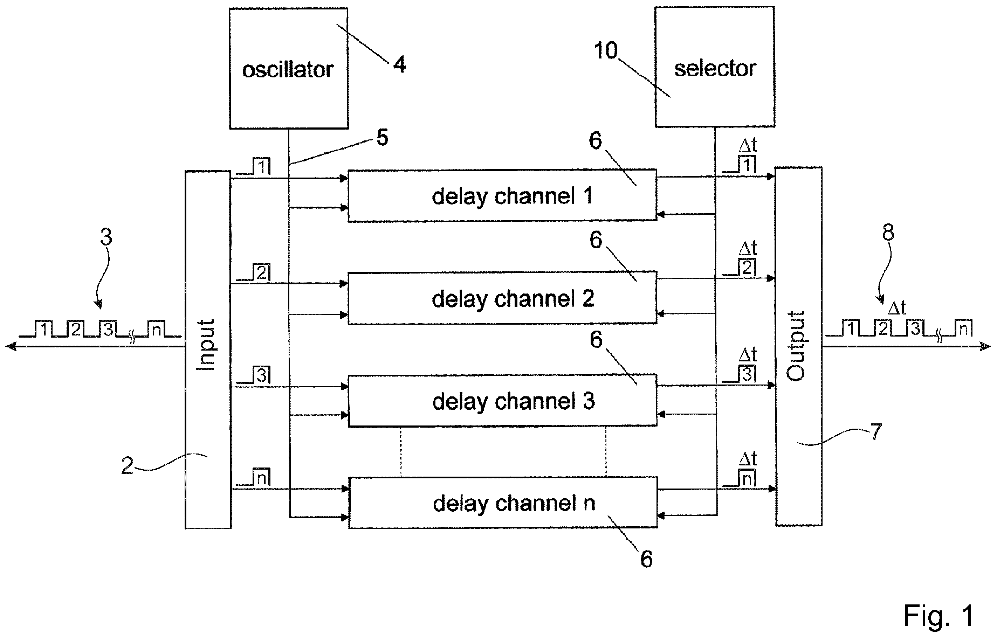

Fig. 1 shows a block diagram of a first embodiment of a time-delay circuit 1 for a digital signal 3, particularly a clock signal, according to the invention. The time-delay circuit 1 comprises an input 2 for the digital signal 3 and an output 7 for a delayed digital signal 8.

The time-delay circuit 1 further comprises an oscillator 4 for generating an internal clock signal 5 and multiple delay channels 6. Each delay channel 6 adds a certain delay to a part of the digital input signal 3 based on the internal clock signal 5. Advantageously, the pulses of the digital input signal 3 are sequentially divided to the different delay channels 6, thereby enhancing the maximum supported input frequency. According to the embodiment of Fig. 1 the time-delay circuit 1 comprises n channels and the first pulse of the input signal 3 is assigned to the first delay channel 6, the second pulse of the input signal 3 is assigned to the second delay channel 6, the third pulse of the input signal 3 is assigned to the third delay channel 6, up to the n-th pulse of the input signal 3 that is assigned to the n-th delay channel 6.

According to the invention the delayed digital signal 8 of the output 7 is an aggregation of the delayed signals of the multiple delay channels 6.

Preferably, the certain delay of the delay channels 6 is adjustable for each delay channel 6. In this way the time-delay circuit 1 can be customized for a particular application, i.e. for providing a certain delayed digital signal 8 at the output 7.

For example, the certain delay of the delay channels 6 is adjustable by dividing the internal clock signal 5 within each delay channel 6. The delay channels 6 can have the same or different delays, for example by using the same division or different divisions of the internal clock signal 5. If the pulses of the digital input signal 3 are sequentially distributed to the different delay channels 6, these delay channels 6 preferably have the same delay.

The time-delay circuit 1 of Fig. 1 further comprises a delay selector 10 for adjusting the certain delay of the multiple delay channels 6, e.g. by amending the division of the internal clock signal 5 within each delay channel 6.

Advantageously, the oscillator 4 is a process, voltage and temperature compensated oscillator 4. Thus, the time-delay circuit 1 according to the invention is less susceptible to process, voltage and temperature variations.

Furthermore, the oscillator 4 is programmable, so that the internal clock signal 5 can be amended before and/or during operation. This further enables customization of the time-delay circuit 1 for different applications and/or variations during operation.

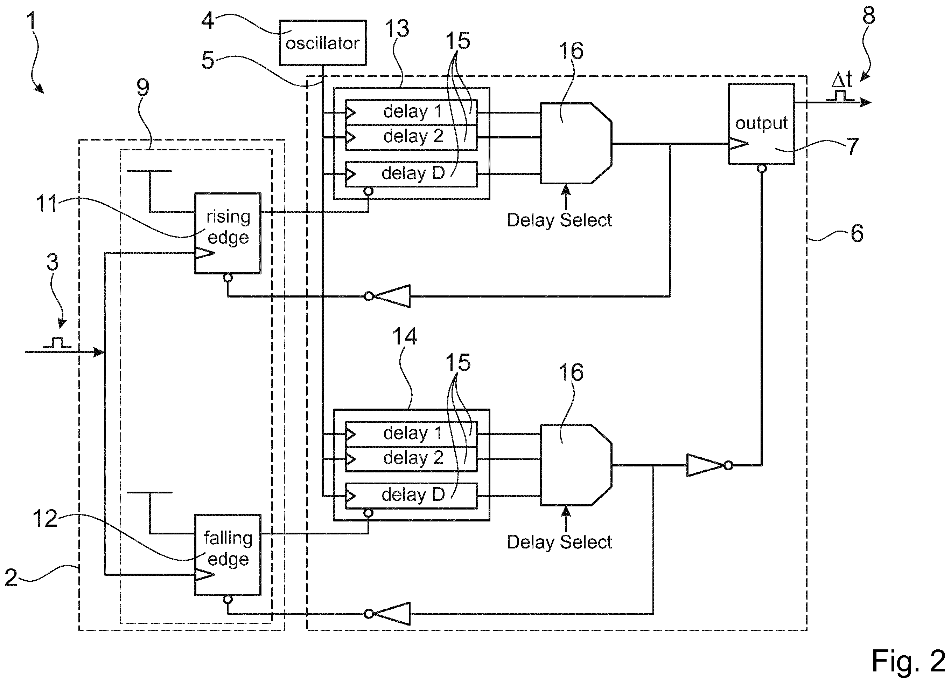

Fig. 2 shows a block diagram of a second embodiment of a time-delay circuit 1 for a digital signal 3, particularly a clock signal, according to the invention. The time-delay circuit 1 of Fig. 2 comprises an input 2 for the digital signal 3, an oscillator 4 for generating an internal clock signal 5, single delay channel 6 and an output 7 for a delayed signal 8. The output of the single delay channel 6 is also the output 7 of the time-delay circuit 1.

According to the second embodiment of Fig. 2 the input 2 comprises an edge detector 9 for the digital input signal 3. The edge detector 9 particularly comprises a rising edge detector 11 (also referred to as rising edge delay enable) and a falling edge detector 12 (also referred to as falling edge delay enable) for detecting the respective edges of the digital input signal 3.

The edge detector 9 assigns the rising edge and the falling edge of the digital input signal 3 to different parts 13, 14 of delay channel 6. Particularly, the delay channel 6 has two separate parts 13, 14, one part 13 for the rising edge of the digital input signal 3 and one part 14 for the falling edge of the digital input signal 3.

According to the second embodiment of Fig. 2 each part 13, 14 of the delay channel 6 comprises multiple delay components 15. Each delay component 15 provides a delay to the input signal 3 of the delay channel 6. In this embodiment the rising and falling edges of the input signal are assigned to parts 13, 14 of the delay channel and each part of the delay channel 6 comprises multiple delay components providing the certain delay for the rising respectively falling edge of the input signal 3. The certain delay of the delay channel 6 is defined by a selection of one or more of the delays provided by the multiple delay components 15.

The time delay circuit 1, particularly the delay channel 6, can further comprises two multiplexers 16, one for each group 13, 14 of delay channels 6. The signals of the multiple delay components 15 of one group 13, 14 are the input of one multiplexer 16 and the multiplexer 16 can select one or more of these delay component signals and forward these signals to the output 7.

The output of the delay channel aggregates the delayed signals for the rising edge and the falling edge and corresponds to the output 7 of the time-delay circuit 1.

Preferably the delay of the delay components 15 is adjustable for each delay component 15. Advantageously, the delay of the delay components 15 is programmable, i.e. can be modified/adapted. For example, the delay of the delay components 15 is adjustable by dividing the internal clock signal 5 within each delay component 15.

The delay channels 6 can have the same or different delays.

Like in the first embodiment shown in Fig. 1 the oscillator 4 is a process, voltage and temperature compensated oscillator 4 and preferably is programmable.

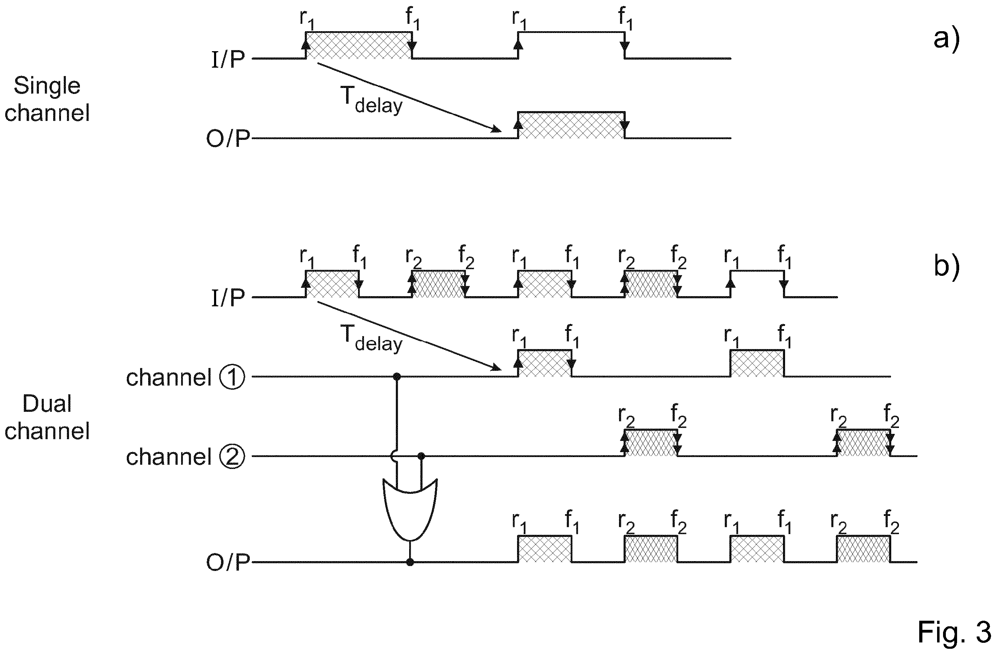

Fig. 3a shows a signal diagram for a single channel 6 time-delay circuit 1 which does not correspond to the claimed subject matter. The upper part shows the digital input signal 3 and the lower part shows the delayed output signal 8. The rising edges r1 and falling edges f1 are marked by corresponding arrows on the signals. The signal diagram for Fig. 3a could refer to the second embodiment of a time-delay circuit 1 shown Fig. 2.

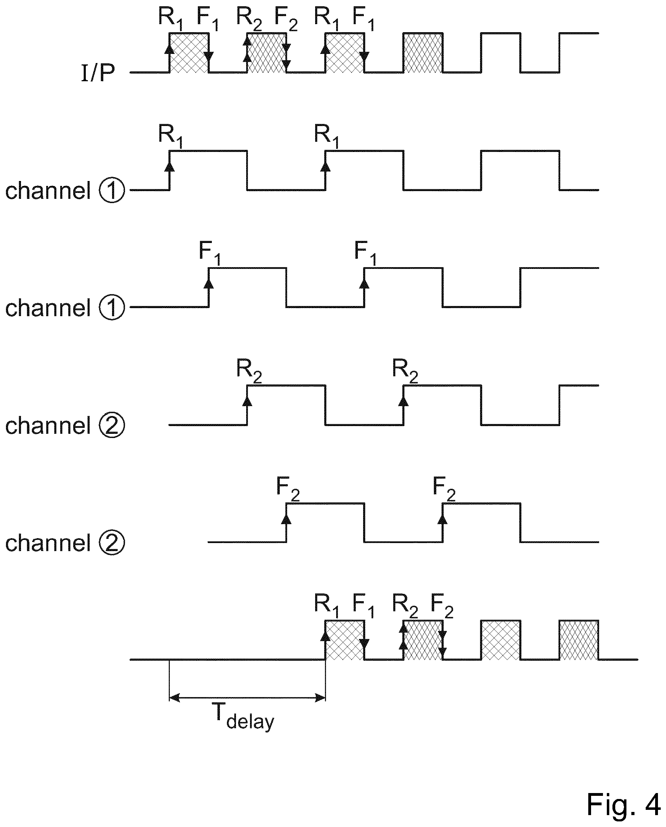

Fig. 3b shows a signal diagram for a dual channel 6 time-delay circuit 1 according to the invention. The input signal 3 is sequentially, i.e. alternating, assigned to the first channel 6 and second channel 6 of the time-delay circuit 1. The first and second channel 6 provide the same time delay. The output signal 8 is an aggregation of the delayed signals of the first and second delay channel 6, symbolized by the OR-element in Fig. 3b. The rising and falling edges are correspondingly marked as r1, r2 respectively f1, f2 or a single or double arrow in Fig. 3b. The rising and falling edges can be delayed by separate delay components 15, as disclosed with respect to Fig. 2 and shown in more detail in Fig. 4.

Fig. 4 shows a signal diagram for a dual channel 6 time-delay circuit 1 with different parts 13, 14 for the rising and falling edges. The rising edges r1 of the input signal 3 are assigned to a first part 13 of the first delay channel 6 and the falling edges f1 of the input signal 3 are assigned to a second part 14 of the first delay channel 6. Accordingly, the rising edges r2 of the input signal 3 are assigned to a first part 13 of the second channel 6 and the falling edges f2 of the input signal 3 are assigned to a second part 14 of the second channel 6.

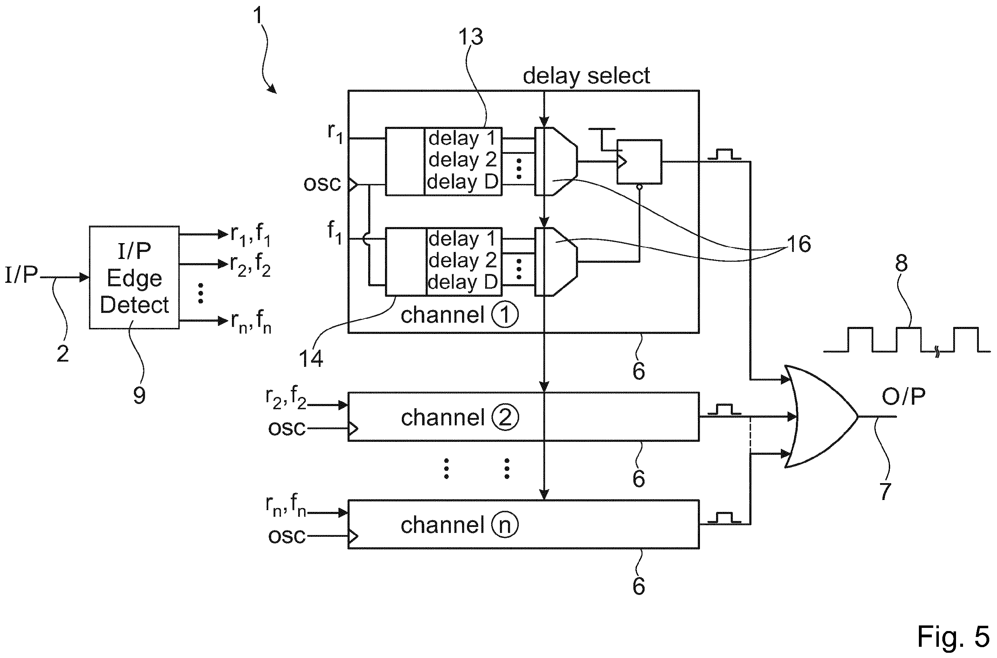

Fig. 5 shows a schematic block diagram of a third embodiment of a time-delay circuit 1 according to the invention. The digital input signal 2 is first divided into rising edges r1-rn and falling edges f1-fn, wherein n is the number of different delay channels 6 of the time-delay circuit 1. The rising and falling edges r1-rn, f1-fn are afterwards sequentially assigned to the different delay channels 6, number 1-n accordingly. Each delay channel 6 comprises a first group 13 of delay components 15 and a second group 14 of delay components 15. The rising edges r1-rn of the signal are processed by the first group 13 of the respective delay channel 6 and the falling edges f1-fn of the signal are processed by the second group 14 of the respective delay channel 6. The delay components 15 in each group 13, 14 provide different delays to the input signal assigned to the delay channel 6, specifically to the rising edge r1-rn or falling edge f1-fn of that signal. A multiplexer 16 selects the signal of that delay component 15 or multiple delay components 15 of both groups 13, 14 that provide the current desired delay. At the output of each delay channel 6 the rising edges r1-rn and falling edges f1-fn are aggregated. The signals of all delay channels 6 numbered 1 to n are aggregated to provide the final output signal 8 at the output 7 of the time-delay circuit shown in Fig. 5. The internal components of the delay channels 6 numbered 2 to n are identical to the details shown in the first delay channel 6. Thus, the third embodiment shown in Fig. 5 is a combination of the first embodiment shown in Fig. 1 and the second embodiment shown in Fig. 2.

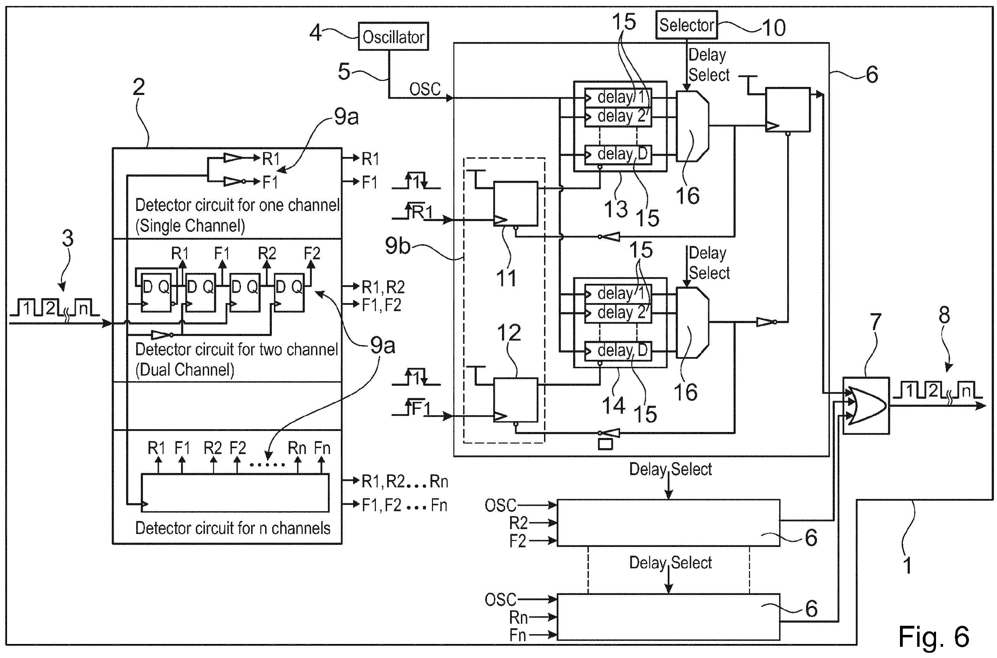

Fig. 6 shows a schematic block diagram of different embodiments of time-delay circuits 1 according to the invention combined in one diagram.

A time-delay circuit 1 for a digital signal 3, particularly for a clock signal, in general comprises an input 2 for the digital signal 3, an oscillator 4 for generating an internal clock signal 5 and one or more delay channels 6, each adding a certain delay to the digital signal 3 based on the internal clock signal, and an output 7 for a delayed digital signal 8.

The internal layout of the input 2 for the digital signal 3 depends on the number of delay channels 6. In case of a single delay channel 6 the pulse of the digital signal 3 are sequentially forwarded to the single delay channel 6. This variant is shown in the upper part of the input 2 in Fig. 6. If the time-delay circuit 1 comprises two separate delay channels 6, the input 2 alternatingly assigns the pulses of the digital input signal 3 to the two delay channels 6. This variant is shown in the middle part of the input 2 in Fig. 6. Alternatively, the time-delay circuit 1 can comprise multiple delay channels 6. In this variant, the input 2 sequentially assigns the pulses of the digital input signal 3 to the different delay channels 6, which is shown in the lower part of the input 2 in Fig. 6. The advantage of multiple delay channels 6 is that higher frequencies of the digital input signal 3 can be supported.

Each delay channel 6 adds a certain delay to the digital input signal 3 respectively a part of the digital input signal 3 in case of multiple delay channels. For multiple delay channels 6, the delayed digital signal 8 at the output 7 of the time-delay circuit 1 is an aggregation of the delayed parts of the input signal 3 by the multiple delay channels 6. Preferably, the multiple delay 6 channels have the same certain delay, so that digital signal 8 at the output 7 is only delayed compared to the digital input signal 3, without changing the digital signal.

In an advantageous variant of the invention the certain delay of the one or more delay channels 6 is adjustable, for example using a delay selector 10. The certain delay of the one or more delay channels 6 is for example adjustable by dividing the internal clock signal 5.

Advantageously, the oscillator 4 is a process, voltage and temperature compensated oscillator 4. Furthermore, the oscillator 4 can be programmable.

The time-delay circuit 1 comprises an edge detector 9 for the digital input signal 3, wherein the edge detector 9 assigns the rising edge of the digital input signal 3 to a first part of the delay channel 6 and the falling edge of the digital input signal 3 to a second part of the delay channel 6.

According to Fig. 6 the edge detector 9 comprises a first part 9a, referred to as edge detect, separating the rising and falling edges of the digital input signal 3 depending on the number of delay channels 6, particularly by generating pulses R1, F1, R2, F2 to Rn, Fn for the rising and falling edges of the digital input signal 3. This first part 9a of the edge detector 9 is part of the input 2 according to Fig. 6. In case of a single delay channel 6, the first part 9a of the edge detector 9 generates pulses R1 and F1 for the rising and falling edges of the digital input signal 3. In case of two delay channels 6, the first part 9a of the edge detector 9 generates pulses R1, F1 and R2, F2 for alternating pulses of the digital input signal 3. In case of n delay channels 6 the first part 9a of the edge detector 9 generates pulses R1, F1, R2, F2 up to Rn, Fn for sequential pulses of the digital input signal 3. Each delay channels 6 comprises a second part 9b, referred to as delay enable, of the edge detector 9 that detects the generated pulses R1, F1, R2, F2 to Rn, Fn, wherein the first delay channel 6 receives the signals R1, F1, the second delay channel 6 receives the signal R2, F2 up to the n-th delay channel 6 receiving the signal Rn, Fn. The second part 9b of the edge detector 9 in each delay channel 6 comprises a rising edge detector 11 and a falling edge detector 12. Thus, according to the embodiment of Fig. 6 the edge detector 9 is part of the input 2 and each delay channel 6.

The rising and falling edges of the digital input signal 3 are delayed separately within each delay channel 6 and the output of the delay channel 6 aggregates the delayed signals for the rising edge and falling edge.

According to the embodiment shown in Fig. 6 each delay channel 6 comprises multiple delay components 15 each providing a delay to the input signal of the delay channel 6, wherein the certain delay of the at least one delay channel 6 is defined by a selection of one or more of the delays provided by the multiple delay components 15. Particularly, each delay channel 6 comprises a first part 13 and a second part 14 of delay components 15, wherein the first part 13 delays the rising edge of the input signal of the delay channel 6 and the second part 14 delays the falling edge of the input signal of the delay channel 6. The delay channels 6 comprise multiplexer 16 for the first and second part 13, 14 of delay components 15, wherein the multiplexer 16 selects one or more delays provided by the multiple delay components 15. According to Fig. 6 the multiplexers 16 are controlled by the selector 10.

### List of reference numerals

- 1: time-delay circuit
- 2: input
- 3: digital signal
- 4: oscillator
- 5: internal clock signal
- 6: delay channel
- 7: output
- 8: delayed digital signal
- 9: edge detector
- 9a: edge detector (edge detect)
- 9b: edge detector (delay enable)
- 10: channel selector
- 11: rising edge detector
- 12: falling edge detector
- 13: first part of channel group
- 14: second part of channel group
- 15: delay component
- 16: multiplexer

## Claims

1. Time-delay circuit (1) for a digital signal (3), particularly for a clock signal, comprising:
an input (2) for the digital signal (3);
an oscillator (4) for generating an internal clock signal (5);
at least one delay channel (6) adding a certain delay to the digital input signal (3) based on the internal clock signal (5); and
an output (7) for a delayed digital signal (8),
wherein the time-delay circuit (1) comprises multiple delay channels (6) and the digital input signal (3) is split into parts and assigned to different delay channels (6), wherein each delay channel (6) adds a certain delay to a part of the digital input signal (3) based on the internal clock signal (5), and wherein the delayed digital signal (8) is an aggregation of the delayed parts of the input signal (3) by the multiple delay channels (6),
wherein the time-delay circuit (1) further comprises an edge detector (9) for the digital input signal (3), wherein the edge detector (9) assigns the rising edge of the digital input signal (3) to a first part of the delay channels (6) and the falling edge of the digital input signal (3) to a second part of the delay channel (6).

2. Time-delay circuit (1) according to claim 1,
wherein the multiple delay channels (6) have the same or different delays.

3. Time-delay circuit (1) according to any of claims 1 to 2, wherein the certain delay of the at least one delay channel (6) is adjustable, particularly for each delay channel (6).

4. Time-delay circuit (1) according to claim 3,
further comprising a delay selector (10) for adjusting the certain delay of the at least one delay channel (6).

5. Time-delay circuit (1) according to any of claims 1 to 4,
wherein the certain delay of the at least one delay channel (6) is adjustable by dividing the internal clock signal (5), preferably within each channel for multiple delay channels (6).

6. Time-delay circuit (1) according to any of claims 1 to 5,
wherein the oscillator (4) is a process, voltage and temperature compensated oscillator (4).

7. Time-delay circuit (1) according to any of claims 1 to 6,
wherein the edge detector (9) is part of the input (2) of the time-delay-circuit (1) and/or part of the delay channel (6), particularly of each of the multiple delay channels (6).

8. Time-delay circuit (1) according to any of claims 1 to 7,
wherein the output of the delay channel (6) aggregates the delayed signals for the rising edge and the falling edge.

9. Time-delay circuit (1) according to any of claims 1 to 8,
wherein the at least one delay channel (6) comprises multiple delay components (15) each providing a delay to the input signal of the delay channel (6), wherein the certain delay of the at least one delay channel (6) is defined by a selection of one or more of the delays provided by the multiple delay components (15).

10. Time-delay circuit (1) according to claim 9,
wherein the at least one delay channel (6) comprises a multiplexer (16) for selecting the one or more delays provided by the multiple delay components (15).

11. Time-delay-circuit (1) according to claim 8 or claim 9,
wherein the multiple delay components (15) are programmable.

12. Time-delay circuit (1) according to any of claims 1 to 11, wherein the oscillator (4) is programmable.

## Patentansprüche

1. Zeitverzögerungsschaltung (1) für ein digitales Signal (3), insbesondere für ein Taktsignal, aufweisend:
einen Eingang (2) für das digitale Signal (3);
einen Oszillator (4) zur Erzeugung eines internen Taktsignals (5);
mindestens einen Verzögerungskanal (6), der dem digitalen Eingangssignal (3) auf der Grundlage des internen Taktsignals (5) eine bestimmte Verzögerung hinzufügt; und
einen Ausgang (7) für ein verzögertes digitales Signal (8),
wobei die Zeitverzögerungsschaltung (1) mehrere Verzögerungskanäle (6) aufweist und das digitale Eingangssignal (3) in Teile aufgeteilt und verschiedenen Verzögerungskanälen (6) zugewiesen ist, wobei jeder Verzögerungskanal (6) einem Teil des digitalen Eingangssignals (3) auf der Grundlage des internen Taktsignals (5) eine bestimmte Verzögerung hinzufügt, und wobei das verzögerte digitale Signal (8) eine Aggregation der verzögerten Teile des Eingangssignals (3) durch die mehreren Verzögerungskanäle (6) ist,
wobei
die Zeitverzögerungsschaltung (1) weiterhin einen Flankendetektor (9) für das digitale Eingangssignal (3) aufweist, wobei der Flankendetektor (9) die ansteigende Flanke des digitalen Eingangssignals (3) einem ersten Teil der Verzögerungskanäle (6) und die abfallende Flanke des digitalen Eingangssignals (3) einem zweiten Teil des Verzögerungskanals (6) zuordnet.

2. Zeitverzögerungsschaltung (1) nach Anspruch 1,
wobei die mehreren Verzögerungskanäle (6) die gleichen oder unterschiedliche Verzögerungen aufweisen.

3. Zeitverzögerungsschaltung (1) nach einem der Ansprüche 1 bis 2,
wobei die bestimmte Verzögerung des mindestens einen Verzögerungskanals (6) einstellbar ist, insbesondere für jeden Verzögerungskanal (6).

4. Zeitverzögerungsschaltung (1) nach Anspruch 3,
ferner aufweisend einen Verzögerungswähler (10) zum Einstellen der bestimmten Verzögerung des mindestens einen Verzögerungskanals (6).

5. Zeitverzögerungsschaltung (1) nach einem der Ansprüche 1 bis 4,
wobei die bestimmte Verzögerung des mindestens einen Verzögerungskanals (6) durch Teilung des internen Taktsignals (5) einstellbar ist, vorzugsweise innerhalb jedes Kanals bei mehreren Verzögerungskanälen (6).

6. Zeitverzögerungsschaltung (1) nach einem der Ansprüche 1 bis 5,
wobei der Oszillator (4) ein prozess-, spannungs- und temperaturkompensierter Oszillator (4) ist.

7. Zeitverzögerungsschaltung (1) nach einem der Ansprüche 1 bis 6,
wobei der Flankendetektor (9) Teil des Eingangs (2) der Zeitverzögerungsschaltung (1) und/oder Teil des Verzögerungskanals (6), insbesondere jedes der mehreren Verzögerungskanäle (6), ist.

8. Zeitverzögerungsschaltung (1) nach einem der Ansprüche 1 bis 7,
wobei der Ausgang des Verzögerungskanals (6) die verzögerten Signale für die steigende und die fallende Flanke aggregiert.

9. Zeitverzögerungsschaltung (1) nach einem der Ansprüche 1 bis 8,
wobei der mindestens eine Verzögerungskanal (6) mehrere Verzögerungskomponenten (15) aufweist, die jeweils eine Verzögerung für das Eingangssignal des Verzögerungskanals (6) bereitstellen, wobei die bestimmte Verzögerung des mindestens einen Verzögerungskanals (6) durch eine Auswahl einer oder mehrerer der von den mehreren Verzögerungskomponenten (15) bereitgestellten Verzögerungen definiert ist.

10. Zeitverzögerungsschaltung (1) nach Anspruch 9,
wobei der mindestens eine Verzögerungskanal (6) einen Multiplexer (16) zur Auswahl der einen oder mehreren Verzögerungen aufweist, die von den mehreren Verzögerungskomponenten (15) bereitgestellt werden.

11. Zeitverzögerte Schaltung (1) nach Anspruch 8 oder Anspruch 9,
wobei die mehrfachen Verzögerungskomponenten (15) programmierbar sind.

12. Zeitverzögerungsschaltung (1) nach einem der Ansprüche 1 bis 11,
wobei der Oszillator (4) programmierbar ist.

## Revendications

1. Circuit temporisé (1) pour un signal numérique (3), en particulier pour un signal d'horloge, comprenant :
une entrée (2) pour le signal numérique (3) ;
un oscillateur (4) pour générer un signal d'horloge interne (5) ;
au moins un canal de retard (6) ajoutant un certain retard au signal d'entrée numérique (3) en fonction du signal d'horloge interne (5) ; et
une sortie (7) pour un signal numérique retardé (8),
dans lequel le circuit temporisé (1) comprend plusieurs canaux de retard (6) et le signal d'entrée numérique (3) est divisé en parties et affecté à différents canaux de retard (6), chaque canal de retard (6) ajoute un certain retard à une partie du signal d'entrée numérique (3) sur la base du signal d'horloge interne (5), et le signal numérique retardé (8) est une agrégation des parties retardées du signal d'entrée (3) par les multiples canaux de retard (6),
dans lequel
le circuit temporisé (1) comprend en outre un détecteur de front (9) pour le signal d'entrée numérique (3), dans lequel le détecteur de front (9) affecte le front montant du signal d'entrée numérique (3) à une première partie des canaux de retard (6) et le front descendant du signal d'entrée numérique (3) à une deuxième partie du canal de retard (6).

2. Circuit temporisé (1) selon la revendication 1,
dans lequel les multiples canaux de retard (6) ont des retards identiques ou différents.

3. Circuit temporisé (1) selon l'une des revendications 1 à 2,
dans lequel le certain retard du au moins un canal de retard (6) est réglable, en particulier pour chaque canal de retard (6).

4. Circuit temporisé (1) selon la revendication 3,
comprenant en outre un sélecteur de retard (10) pour régler le certain retard de l'au moins un canal de retard (6).

5. Circuit temporisé (1) selon l'une des revendications 1 à 4,
dans lequel le retard déterminé du au moins un canal de retard (6) est réglable en divisant le signal d'horloge interne (5), de préférence dans chaque canal pour les canaux de retard multiples (6).

6. Circuit temporisé (1) selon l'une des revendications 1 à 5,
dans lequel l'oscillateur (4) est un oscillateur (4) compensé en fonction du processus, de la tension et de la température.

7. Circuit temporisé (1) selon l'une des revendications 1 à 6,
le détecteur de front (9) fait partie de l'entrée (2) du circuit temporisé (1) et/ou du canal de retard (6), en particulier de chacun des multiples canaux de retard (6).

8. Circuit temporisé (1) selon l'une des revendications 1 à 7,
dans lequel la sortie du canal de retard (6) regroupe les signaux retardés pour le front montant et le front descendant.

9. Circuit temporisé (1) selon l'une des revendications 1 à 8,
dans lequel le au moins un canal de retard (6) comprend plusieurs composants de retard (15) fournissant chacun un retard au signal d'entrée du canal de retard (6), le retard déterminé du au moins un canal de retard (6) étant défini par une sélection d'un ou de plusieurs des retards fournis par les multiples composants de retard (15).

10. Circuit temporisé (1) selon la revendication 9,
dans lequel le canal de retard au moins (6) comprend un multiplexeur (16) pour sélectionner le ou les retards fournis par les multiples composants de retard (15).

11. Circuit temporisé (1) selon la revendication 8 ou la revendication 9,
dans lequel les multiples composants de retard (15) sont programmables.

12. Circuit temporisé (1) selon l'une des revendications 1 à 11,
dans lequel l'oscillateur (4) est programmable.
